# EUROPEAN PATENT SPECIFICATION

(11) **EP 4 462 935 B1**
(45) Date of publication and mention of the grant of the patent: **17.06.2026**
(21) Application number: 22917796.9
(22) Date of filing: 06.01.2022
(51) Int. Cl.: H04W 74/08, H04L 69/04

(54) **DATA COMPRESSION METHOD AND APPARATUS**
VERFAHREN UND VORRICHTUNG ZUR DATENKOMPRIMIERUNG
PROCÉDÉ ET APPAREIL DE COMPRESSION DE DONNÉES

(43) Date of publication of application: 13.11.2024
(73) Proprietor: Beijing Xiaomi Mobile Software Co., Ltd., Beijing 100085 (CN)
(72) Inventor: WU, Yumin, Beijing 100085 (CN)
(74) Representative: Zimmermann, Tankred Klaus
(86) International application number: PCT/CN2022/070565
(87) International publication number: WO 2023/130321

(56) References cited:
- CN-A- 112 913 315
- CN-A- 113 853 028
- INTEL CORPORATION: "CP-SDT remaining open issues", vol. RAN WG2, no. Electronic meeting; 20210519 - 20210527, 11 May 2021 (2021-05-11), XP052006625, Retrieved from the Internet <URL:https://ftp.3gpp.org/tsg_ran/WG2_RL2/TSGR2_114-e/Docs/R2-2104882.zip R2-2104882_CP-SDT-leftovers.docx> [retrieved on 20210511]
- INTEL CORPORATION: "User plane leftover issues on SDT mechanism", vol. RAN WG2, no. Electronic meeting; 20210816 - 20210827, 6 August 2021 (2021-08-06), XP052034022, Retrieved from the Internet <URL:https://ftp.3gpp.org/tsg_ran/WG2_RL2/TSGR2_115-e/Docs/R2-2107295.zip R2-2107295_UP-SDT-leftovers.docx> [retrieved on 20210806]
- ZTE ET AL: "The issues on user plane common aspects for SDT", vol. RAN WG2, no. eMeeting; 20210412 - 20210420, 1 April 2021 (2021-04-01), XP051992001, Retrieved from the Internet <URL:https://ftp.3gpp.org/tsg_ran/WG2_RL2/TSGR2_113bis-e/Docs/R2-2103018.zip R2-2103018_User plane common aspects for SDT_v1.docx> [retrieved on 20210401]
- INTEL CORPORATION: "User plane aspects for SDT", 3GPP DRAFT; R2-2102840, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG2, no. Electronic meeting; 20210412 - 20210420, 2 April 2021 (2021-04-02), Mobile Competence Centre ; 650, route des Lucioles ; F-06921 Sophia-Antipolis Cedex ; France, XP052174415
- LG ELECTRONICS: "[AT116-e][503][SData] UP SDT open issues (LG)", 3GPP TSG-RAN2 #116-E R2-210XXXX. 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, no. Electronic meeting November 1 – November 12, 2021, 12 November 2021 (2021-11-12), pages 1 - 19, XP093076196

## Description

### TECHNICAL FIELD

The present invention or disclosure relates to the technical field of communications, and more particularly, to a method and an apparatus for data compression.

### BACKGROUND

In the related technology, it is proposed to support small data transmission (SDT) in an inactive state, and SDT can support both SDT based on random access process and SDT based on semi-static configuration.

The packet header compression function for packets in 5G systems includes robust header compression (ROHC) and Ethernet header compression (EHC). When the terminal device is switching, or changing from the connected state to the inactive state, in order to ensure that the terminal device may continuously compress the data packets, the network side device may be configured to instruct the terminal device to retain the current compression context.

INTEL CORPORATION: "CP-SDT remaining open issues", 3GPP DRAFT; R2-2104882, 3RD GENERATION PARTNERSHIP PROJECT (3GPP), MOBILE COMPETENCE CENTRE; 650, ROUTE DES LUCIOLES; F-06921 SOPHIA-ANTIPOLIS CEDEX; FRANCE, vol. RAN WG2, no. Electronic meeting; 20210519 - 20210527, 11 May 2021 (2021-05-11), discusses control plane remaining open items for SDT addressing additional RAN2 details on the handling of non-SDT data for CCCH vs DCCH based approach during an ongoing SDT session, delta signaling for SDT configuration, SDT configuration signaling , UE behaviour during SDT, RRC signaling allowed and PHR details.

INTEL CORPORATION: "User plane leftover issues on SDT mechanism", 3GPP DRAFT; R2-2107295, 3RD GENERATION PARTNERSHIP PROJECT (3GPP), MOBILE COMPETENCE CENTRE; 650, ROUTE DES LUCIOLES; F-06921 SOPHIA-ANTIPOLIS CEDEX; FRANCE, vol. RAN WG2, no. Electronic meeting; 20210816 - 20210827, 6 August 2021 (2021-08-06), discusses user plane remaining open items for SDT addressing RoHC state continuity and suppression of the PDCP status report across SDT session, data volume threshold, logical channel handling and PHR usage.

ZTE ET AL: "The issues on user plane common aspects for SDT", 3GPP DRAFT; R2-2103018, 3RD GENERATION PARTNERSHIP PROJECT (3GPP), MOBILE COMPETENCE CENTRE ; 650, ROUTE DES LUCIOLES; F-06921 SOPHIA-ANTIPOLIS CEDEX; FRANCE, vol. RAN WG2, no. eMeeting; 20210412 - 20210420, 1 April 2021 (2021-04-01), is trying to identify the open issues for user plane common aspect of SDT.

### SUMMARY

Embodiments of the present invention provide a method and an apparatus for data compression so that a terminal device may perform data compression in a target data compression area while performing an SDT, thus improving a performance of data transmission.

The invention is set forth in the appended claims.

### BRIEF DESCRIPTION OF THE DRAWINGS

In order to explain technical solutions of embodiments of the invention or the related art more clearly, the drawings describing embodiments of the invention or required in the related art will be briefly introduced below.
FIG. 1 is a diagram illustrating an architecture of a communication system according to embodiments of the present invention.
FIG. 2 is a flowchart illustrating a method for data compression according to embodiments of the present invention.
FIG. 3 is a flowchart illustrating another method for data compression according to embodiments of the present invention.
FIG. 4 is a flowchart illustrating yet another method for data compression according to embodiments of the present invention.
FIG. 5 is a flowchart illustrating yet another method for data compression according to embodiments of the present invention.
FIG. 6 is a flowchart illustrating yet another method for data compression according to embodiments of the present invention.
FIG. 7 is a structure diagram illustrating a communication apparatus according to embodiments of the present invention.
FIG. 8 is a structure diagram illustrating another communication apparatus according to embodiments of the present invention.
FIG. 9 is a structure diagram illustrating a chip according to embodiments of the present invention.

### DETAILED DESCRIPTION

In order to better understand a method and apparatus for data compression in embodiments of the invention, a communication system to which embodiments of the present invention are applicable is described below.

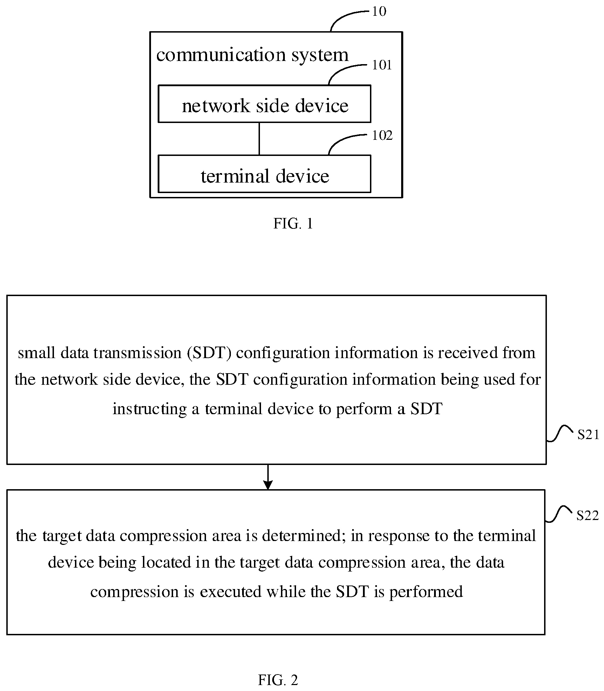

FIG. 1 is a diagram illustrating an architecture of a communication system according to embodiments of the present invention. The communication system may include, but is not limited to, one network side device and one terminal device. A number and a form of the devices shown in FIG. 1 are only for example and do not constitute a limitation to embodiments of the present invention, and two or more network side devices and two or more terminal devices may be included in practical applications. The communication system as illustrated in FIG. 1 includes one network side device 101 and one terminal device 102 for example.

It needs to be noted that technical solutions in embodiments of the present invention are applicable to various communication systems. For example, a long term evolution (LTE) system, a 5th generation (5G) mobile communication system, a 5G new radio (NR) system or other future new mobile communication systems. It needs to be noted that a sidelink in embodiments of the invention may be a side link or a direct link.

The network side device 101 in embodiments of the invention is an entity for transmitting or receiving a signal at a network side. For example, the network side device 11 may be an evolved NodeB (eNB), a transmission reception point (TRP), a next generation NodeB (gNB) in a NR system, a base station in other future mobile communication systems, or an access node in a wireless fidelity (WiFi) system. A specific technology and a specific device form adopted by the network side device are not limited in embodiments of the present invention. The network side device according to embodiments of the present invention may consist of a central unit (CU) and a distributed unit (DU). The CU may also be referred to as a control unit. The protocol layers of a network side device such as a base station may be split by using a structure of the CU-DU, so that the functions for a part of the protocol layers are placed in the CU for centralized control, and functions of a remaining part or all of the protocol layers are distributed in the DU, and the DU is centrally controlled by the CU.

The terminal device 102 in embodiments of the invention is an entity for receiving or transmitting a signal at a user side, for example, a mobile phone. The terminal device may be referred to as a terminal, a user equipment (UE), a mobile station (MS), a mobile terminal (MT), etc. The terminal device may be an automobile with a communication function, a smart automobile, a mobile phone, a wearable device, a tablet computer (Pad), a computer with a wireless transceiver function, a virtual reality (VR) terminal device, an augmented reality (AR) terminal device, a wireless terminal device in industrial control, a wireless terminal device in self-driving, a wireless terminal device in a remote medical surgery, a wireless terminal device in a smart grid, a wireless terminal device in transportation safety, a wireless terminal device in a smart city, a wireless terminal device in a smart home, etc. A specific technology adopted by the terminal device and a specific device form adopted by the terminal device are not limited in embodiments of the present invention.

It may be understood that, the communication system described in embodiments of the present invention are intended to explain technical solutions of embodiments of the present invention more clearly, and does not constitute a limitation to the technical solutions provided by embodiments of the present invention. Those skilled in the art know that, with evolution of a system architecture and emergence of a new business scenario, the technical solutions provided in embodiments of the present invention are equally applied to similar technical problems.

A method and an apparatus for data compression in the invention are further described in combination with attached drawings.

In the related art, when the network side device configures a bearer of the terminal device to use a small data sending function, it is necessary to configure the terminal device with a packet header compression function ( for example, ROHC or EHC) in order to allow the small data sending function to carry out the data compression. How to enable the terminal device to continuously compress data, and how to enable the network side device and terminal device to understand the area where a continuous data compression may be carried out in a same way remain a problem.

In view of the above, an embodiment of the present invention provides a method for data compression so that for a bearer configured for small data transmission, the network side device and the terminal device have the same understanding of the area where the data compression may be carried out, thus enabling the terminal device to perform the data compression in the target data compression area while performing small data transmission, thus improving a performance of data transmission.

FIG. 2 is a flowchart illustrating a method for data compression according to embodiments of the present invention.

As shown in FIG. 2, the method is executed by a terminal device, which may include, but is not limited to the following steps S21-S22.

At S21: small data transmission (SDT) configuration information is received from the network side device, the SDT configuration information being used for instructing a terminal device to perform an SDT.

In embodiments of the present invention, the network side device sends the SDT configuration information to the terminal device, and for example, the network side device instructs the SDT configuration information in an RRCRelease (Radio Resource Control release) message to instruct the terminal device to perform the SDT to send and receive data via the SDT process.

At S22: the target data compression area is determined; in response to the terminal device being located in the target data compression area, the data compression is executed while the SDT is performed.

In embodiments of the present invention, the terminal device determines the target data compression area, which may be specified by the protocol, or the network side device configures or preconfigures for the terminal device, or the target data compression area is determined from other devices, and embodiments of the present invention do not impose any specific limitations thereon.

It may be understood that in embodiments of the present invention, the terminal device, after determining the target data compression area, is thus able to execute the data compression while performing the SDT when in the target data compression area.

In some embodiments, in response to the terminal device being located in the target data compression area, executing the data compression while performing the SDT may include the following steps.

In response to a cell in which the terminal device currently resides, or a cell reselected, or a cell selected, or a type of the access network reselected belonging to the target data compression area, the data compression is executed while the SDT is performed.

In some embodiments, the terminal device executing the data compression may include at least one of the following steps.

Maintain a compressed state of a compressed entity during a packet data convergence protocol (PDCP) reestablishment.

Maintain a compressed state of a decompressed entity is maintained during a PDCP reestablishment.

Maintain a compressed state of a compressed entity during a PDCP recovery.

Maintain a compressed state of a decompressed entity during a PDCP recovery.

Maintain a compressed state of a compressed entity during a radio resource control (RRC) connection recovery.

Maintain a compressed state of a decompressed entity during a RRC connection recovery.

Maintain a compressed state of a compressed entity during a RRC connection release.

Maintain a compressed state of a decompressed entity during a RRC connection release.

The compressed state of the compressed entity is maintained during the PDCP reestablishment. For example, the compressed entity is not reset or the compression context is retained.

The compressed state of the decompressed entity is maintained during the PDCP reestablishment. For example, the decompression is not reset or the decompression context is retained.

The compressed state of the compressed entity is maintained during a PDCP recovery. For example, the compressed entity is not reset or the compression context is retained.

The compressed state of the decompressed entity is maintained during the PDCP recovery. For example, the decompression is not reset or the decompression context is retained.

The compressed state of the compressed entity is maintained during the RRC connection recovery. For example, the compressed entity is not reset or the compression context is retained.

The compressed state of the decompressed entity is maintained during the RRC connection recovery. For example, the decompression is not reset or the decompression context is retained.

The compressed state of the compressed entity is maintained during the RRC connection release. For example, the compressed entity is not reset or the compression context is retained.

The compressed state of the decompressed entity is maintained during the RRC connection release. For example, the decompression is not reset or the decompression context is retained.

In some embodiments, a method for data compression is provided in embodiments of the present invention and further includes the following step.

In response to the terminal device being not located in the target data compression area, the data compression is not executed while the SDT is performed.

It will be understood that in embodiments of the present invention, the terminal device, after determining the target data compression area, is thus able to stop executing the data compression while performing the SDT when in the target data compression area.

In some embodiments, the terminal device stopping executing the data compression may include at least one of the following steps.

Reset a compressed entity during a PDCP reestablishment.

Reset a decompressed entity during a PDCP reestablishment.

Reset a compressed entity during a PDCP recovery.

Reset a decompressed entity during a PDCP recovery.

Reset a compressed entity during a RRC connection recovery.

Reset a decompressed entity during a RRC connection recovery.

Reset a compressed entity during a RRC connection release.

Reset a decompressed entity during a RRC connection release.

Release the data compression area configuration.

Enter an idle state.

By implementing embodiments of the present invention, the terminal device may receive the SDT configuration information from the network side device, the SDT configuration information being used for instructing the terminal device to perform the SDT, may determine a target data compression area, and in response to the terminal device being located in the target data compression area, may execute the data compression while performing the SDT. In this way, the terminal device may perform data compression in the target data compression area while performing the SDT, thereby improving the performance of data transmission.

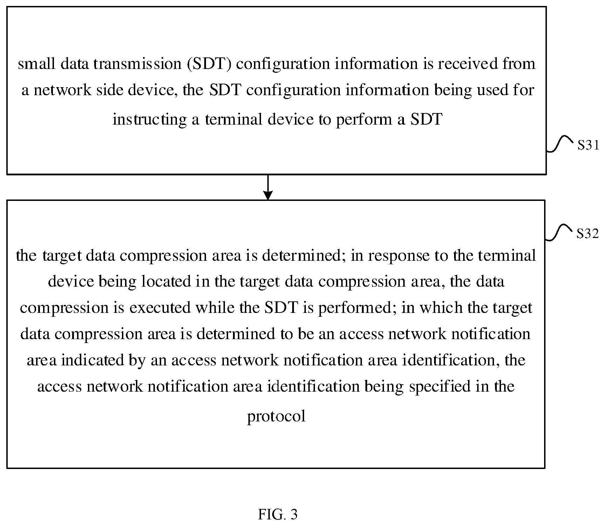

FIG. 3 is a flowchart illustrating another method for data compression according to embodiments of the present invention.

As shown in FIG. 3, the method is executed by a terminal device, and the method may include, but is not limited to the following steps S31-S32.

At S31: small data transmission (SDT) configuration information is received from a network side device, the SDT configuration information being used for instructing a terminal device to perform an SDT.

The detailed description of step S31 in an embodiment of the present invention may be referred to the relevant description of step S21 in the above example, which will not be repeated herein.

At S32: the target data compression area is determined; in response to the terminal device being located in the target data compression area, the data compression is executed while the SDT is performed; in which the target data compression area is determined to be an access network notification area indicated by an access network notification area identification, the access network notification area identification being specified in the protocol.

In embodiments of the present invention, the terminal device determines the target data compression area to be the access network notification area indicated by the access network notification area identification, according to the access network notification area identification specified in the protocol.

**In** some embodiments, the access network notification area identification specified in the protocol includes any one of the following.

For the configured grant-small data transmission (CG-SDT), the access network notification area identification is a notification area identification of an access network to which a cell configured with the CG-SDT resource belongs.

The access network notification area identification is a notification area identification of an access network to which a cell, in which the terminal device receives a connection suspension message, belongs.

The access network notification area identification is a notification area identification of an access network to which a cell, in which the terminal device receives a connection release message, belongs.

For the configured grant-small data transmission (CG-SDT), the access network notification area identification is the notification area identification of the access network to which a cell configured with the CG-SDT resource belongs. For example, the cell configured with the CG-SDT resource is cell #1, and cell #1 belongs to the access network indicated by the access network notification area identification ( for example, RNA-1 (RAN-based Notification Area)).

The access network notification area identification is the notification area identification of the access network to which a cell, in which the terminal device receives a connection suspension message, belongs. For example, the cell in which the terminal device receives the connection suspension message is cell #2, and cell #2 belongs to the access network indicated by the access network notification area identification (for example, RNA-1).

The access network notification area identification is the notification area identification of the access network to which a cell, in which the terminal device receives a connection release message, belongs. For example, the cell in which the terminal device receives the connection release message is cell #3, and cell #3 belongs to the access network indicated by the access network notification area identification (for example, RNA-1).

In some embodiments, in response to the terminal device being located in the target data compression area, executing the data compression while performing the SDT may include the following steps.

In response to a cell in which the terminal device currently resides, or a cell reselected, or a cell selected, or a type of the access network reselected belonging to the target data compression area, the data compression is executed while an SDT is performed.

For example, in case the access network notification area identification is specified in the protocol, the terminal device determines to be in the target data compression area when the cell in which the terminal device currently resides belongs to the access network indicated by the access network notification area identification.

For example, in case the access network notification area identification is specified in the protocol, the terminal device determines to be in the target data compression area when the cell reselected or selected by the terminal device belongs to the access network indicated by the access network notification area identification.

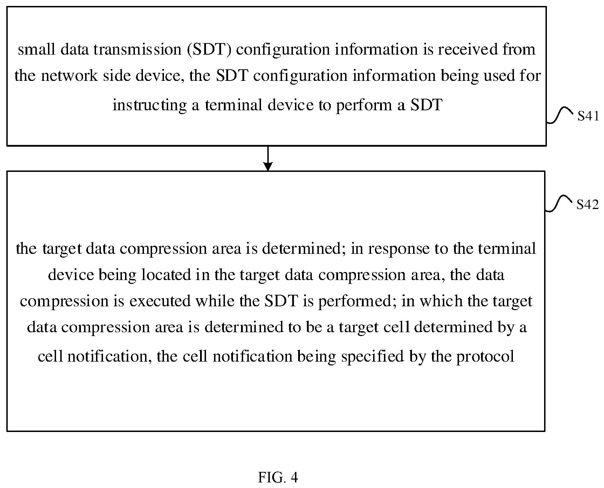

FIG. 4 is a flowchart illustrating yet another method for data compression according to embodiments of the present invention.

As shown in FIG. 4, the method is executed by a terminal device, and the method may include, but is not limited to the following steps S41-S42.

At S41: small data transmission (SDT) configuration information is received from the network side device, the SDT configuration information being used for instructing a terminal device to perform an SDT.

The detailed description of step S41 in an embodiment of the present invention may be referred to the relevant description of step S21 in the above example, which will not be repeated herein.

S42: the target data compression area is determined; in response to the terminal device being located in the target data compression area, the data compression is executed while the SDT is performed; in which the target data compression area is determined to be a target cell determined by a cell notification, the cell notification being specified by the protocol

In embodiments of the present invention, the cell notification is specified by the protocol, and the terminal device determines the target data compression area to be the target cell identified by the cell notification, according to the cell notification specified by the protocol.

In some embodiments, in response to the terminal device being located in the target data compression area, executing the data compression while performing the SDT may include the following steps.

In response to a cell in which the terminal device currently resides, or a cell reselected, or a cell selected, or a type of the access network reselected belonging to the target data compression area, the data compression is executed while the SDT is performed.

For example, in case the cell notification is specified by the protocol, the terminal device determines to be within the target data compression area when the cell in which the terminal device currently resides belongs to the target cell identified by the cell notification.

For example, in case the cell notification is specified by the protocol, the terminal device determines to be within the target data compression area when the cell reselected or selected by the terminal device belongs to the target cell identified by the cell notification.

In some embodiments, the cell notification, includes at least one of the following.

A cell identification;
A cell type identification.

The cell identification is for example cell #1.

The cell type identification is for example, PCell (Primary Cell), or PSCell (Primary Secondary Cell), or SpCell (Special Cell), or SCell (Secondary Cell), etc.

In some embodiments, the cell notification specified by the protocol, includes any of the following.

For the configured grant-small data transmission (CG-SDT), the cell notification is a notification which indicates a cell configured with the configured grant-small data transmission (CG-SDT) resources.

The cell notification is a notification which indicates a cell in which the terminal device receives a connection suspension message.

The cell notification is a notification which indicates a cell in which the terminal device receives a connection release message.

In some embodiments, the cell in which the terminal device receives the connection suspension message includes any of the following.

A cell in which the terminal device successfully receives the connection suspension message.

A cell in which the terminal device receives the connection suspension message for a first time.

A cell in which the terminal device receives the connection suspension message for a last time.

The cell in which the terminal device successfully receives the connection suspension message will be illustrated. For example, the RRCRelease message has 2 segments, segment-1 is sent in cell-1 and segment-2 is sent in cell-2. In case that the terminal device successfully decodes the RRCRelease message after receiving segment-2, then cell-2 is the cell that successfully receives the "connection suspension message" or "connection release message".

The cell in which the terminal device receives the connection suspension message for a first time will be illustrated. For example, the RRCRelease message has 2 segments, segment-1 is sent in cell-1, and segment-2 is sent in cell-2. Cell-1 is the cell that receives the connection suspension message for a first time. In another example, the RRCRelease message is first transmitted through the hybrid automatic repeat request (HARQ) process 1 in cell-1, and then cell-1 is the cell that receives the connection suspension message for a first time.

The cell in which the terminal device receives the connection suspension message for a last time will be illustrated. For example, the RRCRelease message has 2 segments, segment-1 is sent in cell-1 and segment-2 is sent in cell-2. The cell-2 is the cell that receives the connection suspension message for a last time. In another example, the RRCRelease message is transmitted for the last time through the HARQ process 1 in cell-2, or, the terminal device successfully receives the RRCRelease message through the HARQ process 1 in cell-2, and then cell-2is the cell that receives the connection suspension message for a last time.

In some embodiments, the cell in which the terminal device receives the connection release message includes any of the following.

A cell in which the terminal device successfully receives the connection release message.

A cell in which the terminal device receives the connection release message for a first time.

A cell in which the terminal device receives the connection release message for a last time.

The cell in which the terminal device successfully receives the connection release message will be illustrated. For example, the RRCRelease message has 2 segments, segment-1 is sent in cell-1 and segment-2 is sent in cell-2. In case that the terminal device successfully decodes the RRCRelease message after receiving segment-2, then cell-2 is the cell that successfully receives the connection release message.

The cell in which the terminal device receives the connection release message for a first time will be illustrated. For example, the RRCRelease message has 2 segments, segment-1 is sent in cell-1 and segment-2 is sent in cell-2. Cell-1 is the cell that receives the connection release message for a first time. In another example, the RRCRelease message is first transmitted through the HARQ process 1 in cell-1, and cell-1 is the cell that receives the connection release message for a first time.

The cell in which the terminal device receives the connection release message for a last time will be illustrated. For example, the RRCRelease message has 2 segments, segment-1 is sent in cell-1 and segment-2 is sent in cell-2. Cell-2 is the cell that receives the connection release message for a last time. In another example, the RRCRelease message is transmitted for the last time through the HARQ process 1 in cell-2, or, the terminal device successfully receives the RRCRelease message through the HARQ process 1 in cell-2, and cell-2 is the cell that receives the connection release message for a last time.

It is to be noted that in embodiments of the present invention, the above S41 and S42 may be implemented alone, or may also be implemented in combination with any of the other embodiments in the present invention, for example, with S21 and S22 and/or S31 and S32 in the present invention, and embodiments of the present invention are not specifically limited in this regard.

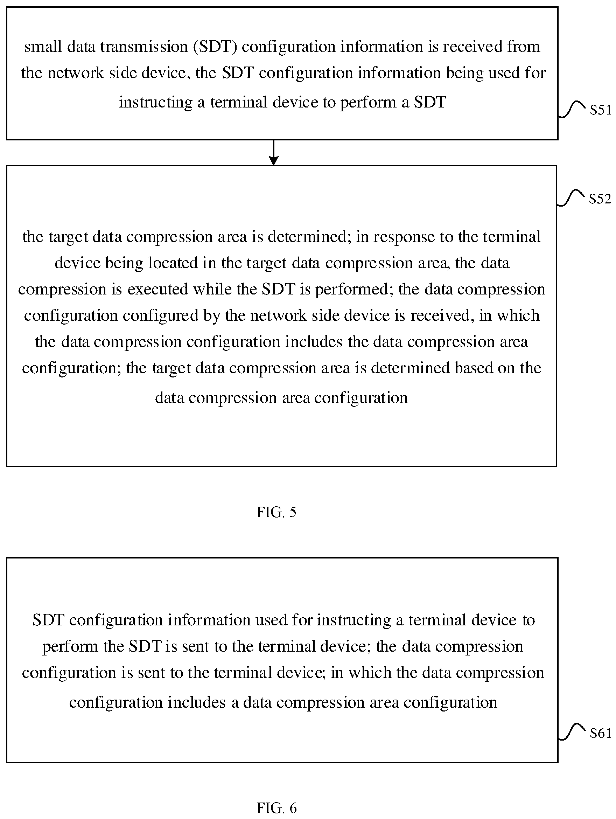

FIG. 5 is a flowchart illustrating yet another method for data compression according to embodiments of the present invention.

As shown in FIG. 5, the method is applied to the terminal device, and the method may include, but is not limited to the following step S51-S52.

At S51: small data transmission (SDT) configuration information is received from the network side device, the SDT configuration information being used for instructing a terminal device to perform an SDT.

The detailed description of step S51 in an embodiment of the present invention may be referred to the relevant description of step S21 in the above example, which will not be repeated herein.

At S52: the target data compression area is determined; in response to the terminal device being located in the target data compression area, the data compression is executed while the SDT is performed; the data compression configuration configured by the network side device is received, in which the data compression configuration includes the data compression area configuration; the target data compression area is determined based on the data compression area configuration.

In some embodiments, determining the target data compression area based on the data compression area configuration includes the following steps.

In case the data compression area configuration is an access network notification area identification, the target data compression area is determined to be the access network notification area indicated by the access network notification area identification.

In embodiments of the present invention, in the data compression configuration configured by the network side device, the data compression area configuration is the access network notification area identification, and the terminal device, based on the data compression configuration configured by the network side device, determines the target data compression area to be the access network notification area indicated by the access network notification area identification.

In some embodiments, in response to the terminal device being located in the target data compression area, executing the data compression while performing the SDT includes the following steps.

In response to a cell in which the terminal device currently resides, or a cell reselected, or a cell selected, or a type of the access network reselected belonging to the target data compression area, the data compression is executed while the SDT is performed.

For example, in case the data compression area configuration is the access network notification area identification, the terminal device determines to be in the target data compression area when the cell in which the terminal device currently resides belongs to the access network notification area indicated by the access network notification area identification.

For example, in case the data compression area configuration is the access network notification area identification, the terminal device determines to be in the target data compression area when the cell in which the terminal device reselected or selected belongs to the access network notification area indicated by the access network notification area identification.

In some embodiments, determining the target data compression area based on the data compression area configuration includes the following steps.

In case the data compression area configuration is a cell notification, the target data compression area is determined to be a target cell determined by the cell notification.

In embodiments of the present invention, in the data compression configuration configured by the network side device, the data compression area configuration is the cell notification, and the terminal device determines the target data compression area to be the target cell determined by the cell notification based on the data compression configuration configured by the network side device.

In some embodiments, in response to the terminal device being located in the target data compression area, executing the data compression while performing the SDT includes the following steps.

In response to a cell in which the terminal device currently resides, or a cell reselected, or a cell selected, or a type of the access network reselected belonging to the target data compression area, the data compression is executed while the SDT is performed.

For example, in case the data compression area configuration is the cell notification, the terminal device determines to be within the target data compression area when the cell in which the terminal device currently resides belongs to the target cell identified by the cell notification.

For example, in case the data compression area configuration is the cell notification, the terminal device determines to be within the target data compression area when the cell in which the terminal device reselected or selected belongs to the target cell identified by the cell notification.

In some embodiments, the cell notification, includes at least one of the following.

A cell identification.

A cell type identification.

The cell identification is for example cell #1.

The cell type identification is for example PCell (Primary Cell), or PSCell (Primary Secondary Cell), or SpCell (Special Cell), or SCell (Secondary Cell), and etc.

In some embodiments, the data compression configuration, further includes the following.

A data compression bearer configuration and a data compression type configuration.

In some embodiments, the data compression bearer configuration, includes at least one of the following.

A bearer type corresponding to the data compression;
A bearer identification corresponding to the data compression.

The bearer type corresponding to the data compression is for example, MCG (Master Cell Group) or SCG (Secondary Cell Group) bearer.

The bearer identification corresponding to the data compression is for example DRB-1 (Data Radio Bearer).

In some embodiments, the data compression type configuration includes at least one of the following.

A type indication corresponding to the data compression.

An indication that the data compression continues.

An indication that the data compression stops.

An indication of a direction of the data compression.

The type indication corresponding to the data compression is for example, EHC, or ROHC, etc.

The indication that the data compression continues and the indication that the data compression stops are for example, drb-ContinueEHC, or drb-ContinueROHC, etc.

The indication of a direction of the data compression is for example, drb-ContinueEHC-UL or drb-ContinueROHC-UL, or drb-ContinueEHC-DL or drb-ContinueROHC-DL, or drb-ContinueEHC or drb-ContinueROHC, etc.

In some embodiments, the terminal device stops executing the data compression includes at least one of the following.

Release the data compression configuration.

Delete the data compression configuration.

Release a compression context corresponding to the data compression configuration.

Delete a compression context corresponding to the data compression configuration.

Releasing the data compression configuration or deleting the data compression configuration is for example deleting the drb-ContinueROHC configuration.

Releasing a compression context corresponding to the data compression configuration or deleting a compression context corresponding to the data compression configuration is for example deleting the compression context of the ROHC entity.

It needs to be noted that, in embodiments of the present invention, the above S51 and S52 may be implemented alone or may also be implemented in combination with any of the other embodiments in the present invention, for example, with S21 and S22 in the present invention, and embodiments of the present invention are not specifically limited in this regard.

FIG. 6 is a flowchart illustrating yet another method for data compression according to embodiments of the present invention.

As shown in FIG. 6, the method is applied to the network side device, and the method may include, but is not limited to the following step S61.

At S61: SDT configuration information used for instructing a terminal device to perform the SDT is sent to the terminal device; the data compression configuration is sent to the terminal device; in which the data compression configuration includes a data compression area configuration.

In embodiments of the present invention, the network side device sends the SDT configuration information to the terminal device. For example, the network side device indicates the SDT configuration information in an RRCRelease (Radio Resource Control release) message to instruct the terminal device to perform the SDT so as to send and receive data through the SDT process.

By implementing embodiments of the present invention, the terminal device may receive small data transmission (SDT) configuration information from a network side device, the SDT configuration information being used for instructing the terminal device to perform the SDT, and the terminal device may receive the data compression configuration configured by the network side device, in which the data compression configuration includes the data compression area configuration. Thus, the terminal device may determine the target data compression area based on the data compression area configuration; and when the terminal device is located in the target data compression area, the data compression is executed while the SDT is performed. In this way, the terminal device may perform data compression in the target data compression area while performing the SDT, thus improving the performance of data transmission.

In some embodiments, the data compression configuration includes at least one of the following.

An access network notification area identification.

A cell notification.

In embodiments of the present invention, the network side device sends the data compression configuration to the terminal device, in which the data compression configuration includes the data compression area configuration. The data compression area configuration includes: the access network notification area identification; or the cell notification, or the access network notification area identification and the cell notification.

In embodiments of the present invention, in the data compression configuration configured by the network side device, the data compression area configuration is the access network notification area identification, and the terminal device, based on the data compression configuration configured in the network side device, determines the target data compression area to be the access network notification area indicated by the access network notification area identification.

In embodiments of the present invention, in the data compression configuration configured by the network side device, the data compression area configuration is the cell notification, and the terminal device determines the target data compression area to be the target cell determined by the cell notification based on the data compression configuration configured by the network side device.

In some embodiments, the cell notification includes at least one of the following.

A cell identification.

A cell type identification.

The cell identification is for example cell #1.

The cell type identification is for example, PCell (Primary Cell), or PSCell (Primary Secondary Cell), or SpCell (Special Cell), or SCell (Secondary Cell), and etc.

In some embodiments, the data compression configuration further includes the following.

A data compression bearer configuration and a data compression type configuration.

In some embodiments, the data compression bearer configuration includes at least one of the following.

A bearer type corresponding to the data compression.

A bearer identification corresponding to the data compression.

The bearer type corresponding to the data compression is for example MCG (Master Cell Group) or SCG (Secondary Cell Group) bearer.

The bearer identification corresponding to the data compression is for example DRB-1 (Data Radio Bearer).

In some embodiments, the data compression type configuration includes at least one of the following.

A type indication corresponding to the data compression.

An indication that the data compression continues.

An indication that the data compression stops.

An indication of a direction of the data compression.

The type indication corresponding to the data compression is for example, EHC, or ROHC, etc.

The indication that the data compression continues and the indication that the data compression stops are for example, drb-ContinueEHC, or drb-ContinueROHC, etc.

The indication of a direction of the data compression is for example, drb-ContinueEHC-UL or drb-ContinueROHC-UL, or drb-ContinueEHC-DL or drb-ContinueROHC-DL, or drb-ContinueEHC or drb-ContinueROHC, etc.

In the above examples of embodiments provided in the present invention, the methods in embodiments of the present invention are described from the perspectives of the network side device and the terminal device, respectively. In order to realize each of the functions in the method provided in the above examples of embodiments of the present invention, the network side device and the terminal device may include a hardware structure, a software module, so that each of the above examples of embodiments functions is implemented in the form of a hardware structure, a software module, or a hardware structure plus a software module. A function of each of the above functions may be performed in the form of the hardware structure, the software module, or the hardware structure plus the software module.

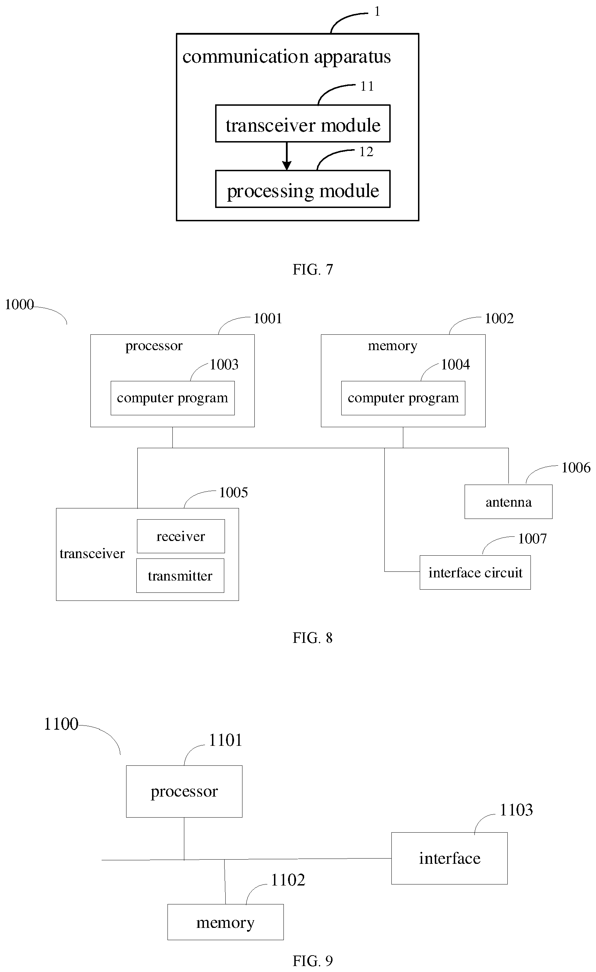

FIG. 7 is a structure diagram illustrating a communication apparatus 1 according to embodiments of the present invention. The communication apparatus 1 shown in FIG. 7 may include a transceiver module 11 and a processing module 12. The transceiver module 11 may include a transmitting module and/or a receiving module, the transmitting module is for realizing a transmitting function, and the receiving module is for realizing a receiving function, and the transceiver module 11 may realize the transmitting function and/or the receiving function.

The communication apparatus 1 may be a terminal device, an apparatus in the terminal device, or an apparatus to be used together with the terminal device.

The communication apparatus 10 is the terminal device and includes a transceiver module 11 and a processing module 12.

The transceiver module 11 is configured to receive SDT configuration information from a network side device, the SDT configuration information being used for instructing a terminal device to perform the SDT.

The processing module 12 is configured to determine a target data compression area; and in response to the terminal device being located in the target data compression area, to execute data compression while performing the SDT.

In some embodiments, the processing module 12 is further configured to, in response to the terminal device being not located in the target data compression area, stop executing data compression while performing the SDT.

In some embodiments, the processing module 12 is specifically configured to determine the target data compression area according to a protocol.

In some embodiments, the processing module 12 is specifically configured to determine the target data compression area to be an access network notification area indicated by an access network notification area identification, the access network notification area identification being specified in the protocol.

In some embodiments, the access network notification area identification specified in the protocol includes any one of the following.

For the configured grant-small data transmission (CG-SDT), the access network notification area identification is a notification area identification of an access network to which a cell configured with the CG-SDT resource belongs.

The access network notification area identification is a notification area identification of an access network to which a cell, in which the terminal device receives a connection suspension message, belongs.

The access network notification area identification is a notification area identification of an access network to which a cell, in which the terminal device receives a connection release message, belongs.

In some embodiments, the processing module 12 is specifically configured to determine the target data compression area to be a target cell determined by a cell notification, the cell notification being specified by the protocol.

In some embodiments, the cell notification includes at least one of the following.

A cell identification.

A cell type identification.

In some embodiments, the cell notification specified in the protocol includes any one of the following.

For the configured grant-small data transmission (CG-SDT), the cell notification is a notification which indicates a cell configured with the configured grant-small data transmission (CG-SDT) resources.

The cell notification is a notification which indicates a cell in which the terminal device receives a connection suspension message.

The cell notification is a notification indicating a cell in which the terminal device receives a connection release message.

In some embodiments, the cell in which the terminal device receives the connection suspension message includes any one of the following.

A cell in which the terminal device successfully receives the connection suspension message.

A cell in which the terminal device receives the connection suspension message for a first time.

A cell in which the terminal device receives the connection suspension message for a last time.

In some embodiments, the cell in which the terminal device receives the connection release message includes any of the following.

A cell in which the terminal device successfully receives the connection release message.

A cell in which the terminal device receives the connection release message for a first time.

A cell in which the terminal device receives the connection release message for a last time.

In some embodiments, the processing module 12 is specifically configured to receive the data compression configuration configured by the network side device, in which the data compression configuration comprises the data compression area configuration; to determine the target data compression area based on the data compression area configuration.

In some embodiments, the processing module 12 is specifically configured to, in case the data compression area configuration is an access network notification area identification, determine the target data compression area to be the access network notification area indicated by the access network notification area identification.

In some embodiments, the processing module 12 is specifically configured to, in case the data compression area configuration is a cell notification, determine the target data compression area to be a target cell determined by the cell notification.

In some embodiments, the cell notification includes at least one of the following.

A cell identification.

A cell type identification.

In some embodiments, the data compression configuration further includes the following.

A data compression bearer configuration and a data compression type configuration.

In some embodiments, the data compression bearer configuration includes at least one of the following.

A bearer type corresponding to the data compression.

A bearer identification corresponding to the data compression.

In some embodiments, the data compression type configuration includes at least one of the following.

A type indication corresponding to the data compression.

An indication in which the data compression continues.

An indication in which the data compression stops.

An indication of a direction of the data compression.

In some embodiments, the processing module 12 is specifically configured to, in response to a cell in which the terminal device currently resides, or a cell reselected, or a cell selected, or a type of the access network reselected belonging to the target data compression area, execute the data compression while performing the SDT.

In some embodiments, the processing module 12 is specifically configured to execute the data compression, including at least one of the following.

Maintain a compressed state of a compressed entity during a packet data convergence protocol (PDCP) reestablishment.

Maintain a compressed state of a decompressed entity during a PDCP reestablishment.

Maintain a compressed state of a compressed entity during a PDCP recovery.

Maintain a compressed state of a decompressed entity during a PDCP recovery.

Maintain a compressed state of a compressed entity during a radio resource control (RRC) connection recovery.

Maintain a compressed state of a decompressed entity during a RRC connection recovery.

Maintain a compressed state of a compressed entity during a RRC connection release.

Maintain a compressed state of a decompressed entity during a RRC connection release.

In some embodiments, the processing module 12 is specifically configured to stop executing the data compression, and includes at least one of the following.

Reset a compressed entity during a PDCP reestablishment.

Reset a decompressed entity during a PDCP reestablishment.

Reset a compressed entity during a PDCP recovery.

Reset a decompressed entity during a PDCP recovery.

Reset a compressed entity during a RRC connection recovery.

Reset a decompressed entity during a RRC connection recovery.

Reset a compressed entity during a RRC connection release.

Reset a decompressed entity during a RRC connection release.

Release the data compression area configuration.

Enter an idle state.

In some embodiments, the processing module 12 is specifically configured to stop executing the data compression, and includes at least one of the following.

Release the data compression configuration.

Delete the data compression configuration.

Release a compression context corresponding to the data compression configuration.

Delete a compression context corresponding to the data compression configuration.

In embodiments of the present invention, the communication apparatus 1 may be the network side device, or an apparatus in the network side device, or an apparatus to be used together with the network side device.

The communication apparatus 1 is the network side device and includes a transceiver module 11.

The transceiver module 11 is configured to send, to the terminal device, SDT configuration information used for instructing a terminal device to perform the SDT; to send the data compression configuration to the terminal device, in which the data compression configuration comprises a data compression area configuration.

In some embodiments, the data compression area configuration includes at least one of the following.

An access network notification area identification.

A cell notification.

In some embodiments, the cell notification includes at least one of the following.

A cell identification.

A cell type identification.

In some embodiments, the data compression configuration further includes the following.

A data compression bearer configuration and a data compression type configuration.

In some embodiments, the data compression bearer configuration includes at least one of the following.

A bearer type corresponding to the data compression.

A bearer identification corresponding to the data compression.

In some embodiments, the data compression type configuration includes at least one of the following.

A type indication corresponding to the data compression.

An indication that the data compression continues.

An indication that the data compression stops.

An indication of a direction of the data compression.

For the communication apparatus 1 in the above embodiments, the specific manner in which each module performs an operation has been described in detail in embodiments relating to the method, which will not be described in detail herein.

The communication apparatus 1 provided in the above embodiments of the present invention achieves the same or similar beneficial effects as the method for configuring resources provided in some of the above embodiments, which will not be described in detail herein.

FIG. 8 is a structure diagram illustrating another communication apparatus 1000 according to embodiments of the present invention. The communication apparatus 1000 may be a network side device, a terminal device, a chip, a system on chip or a processor that supports the network side device to implement the method, or a chip, a system on chip or a processor that supports the terminal device to implement the method. The apparatus 1000 may be configured to implement the method described in the method embodiments, and reference is made to the description of the method embodiments.

The communication apparatus 1000 may include one or more processors 1001. The processor 1001 may include a general purpose processor or a dedicated processor. For example, the processor 1001 may be a baseband processor or a central processor. The baseband processor may be configured to process a communication protocol and communication data, and the central processor may be configured to control a communication apparatus (e.g., a base station, a baseband chip, a terminal device, a terminal device chip, a DU or CU, etc.), to execute a computer program, and process data of the computer program.

Alternately, the communication apparatus 1000 may further include one or more memories 1002 with a computer program 1004 stored thereon. The memory 1002 executes the computer program 1004 so that the communication apparatus 1000 performs the method as described in the above method embodiments. Alternately, the memory 1002 may further store data. The communication apparatus 1000 and the memory 1002 may be independently configured or integrated together.

Alternately, the communication apparatus 1000 may further include a transceiver 1005 and an antenna 1006. The transceiver 1005 may be referred to as a transceiving unit, a transceiver or a transceiving circuit, which may be configured to achieve a transceiving function. The transceiver 1005 may include a receiver and a transmitter. The receiver may be referred to as a receiver or a receiving circuit, etc., for implementing a receiving function; the transmitter may be referred to as a transmitter or a transmitting circuit, etc. for implementing a transmitting function.

Alternately, the communication apparatus 1000 may further include one or more interface circuits 1007. The interface circuit 1007 is configured to receive code instructions and transmit the code instructions to the processor 1001. The processor 1001 runs the code instructions so that the communication apparatus 1000 performs the method according to the above method embodiment.

The communication apparatus 1000 is a terminal device. The transceiver 1005 is configured to execute step S21 in FIG.2; step S31 in FIG. 3; step S41 in FIG. 4; step S41 in FIG. 4; the processor 1001 is configured to execute step S22 in FIG.2; step S32 in FIG.3; step S42 in FIG.4; step S52 in FIG.5.

The communication apparatus 1000 is a network side device. The transceiver 1005 is configured to execute step S61 in FIG.6.

In an implementation, the processor 1001 may include a transceiver configured to implement receiving and transmitting functions. For example, the transceiver may be a transceiving circuit, or an interface, or an interface circuit. The transceiving circuit, the interface or the interface circuit configured to implement receiving and transmitting functions may be separate or integrated together. The transceiving circuit, the interface or the interface circuit may be configured to read and write codes/data, or the transceiving circuit, the interface or the interface circuit may be configured to transmit or deliver a signal.

In an implementation, the processor 1001 may be stored with a computer program 1003. The computer program 1003 runs on the processor 1001 so that the communication apparatus 1000 performs the method as described in the above method embodiments. The computer program 1003 may be solidified in the processor 1001, in which case the processor 1001 may be implemented by a hardware.

In an implementation, the communication apparatus 1000 may include a circuit that may implement a transmitting or receiving or communication function of the above method embodiments. The processor and the transceiver described in the present invention may be implemented on integrated circuits (ICs), analog ICs, radio frequency integrated circuits (RFICs), mixed signal ICs, application specific integrated circuits (ASICs), printed circuit boards (PCBs), electronic devices, etc. The processor and the transceiver may further be fabricated by using various IC process technologies, such as complementary metal oxide semiconductor (CMOS), n-type Metal-oxide-semiconductor (NMOS), positive channel metal oxide semiconductor (PMOS), bipolar junction transistor(BJT), bipolar CMOS(BiCMOS), silicon germanium(SiGe) and gallium arsenide(GaAs).

The communication apparatus described in the above embodiments may be a network device or a terminal device, but the scope of the communication apparatus described in the present invention is not limited thereto, and a structure of the communication apparatus may not be subject to FIG. 8. The communication apparatus may be a stand-alone device or may be a part of a larger device. For example, the communication apparatus may be the following.
(1) a stand-alone integrated circuit (IC), or a chip, or a system on chip or a subsystem;
(2) a set of one or more ICs, optionally, which may also include a storage component for storing data and a computer program;
(3) an ASIC, such as a Modem;
(4) a module that may be embedded within other devices;
(5) a receiver, a terminal device, a smart terminal device, a cellular phone, a wireless device, a handset, a mobile unit, a vehicle device, a network device, a cloud device, an artificial intelligence device, etc.;
(6) others, and so forth.

In the case that the communication apparatus may be a chip or a system on chip, please refer to a diagram of a structure of a chip as illustrated in FIG. 9 in embodiments of the invention.

Chip 1100 includes a processor 1101 and an interface 1103, in which the number of processors 1101 may be one or more and the number of interfaces 1103 may be more than one.

The case where the chip is used to implement the functionality of a terminal device in an embodiment of the present invention will be illustrated.

Interface 1103 is for receiving code instructions and sending code instructions to the processor.

Processor 1101 is for running code instructions to perform a method for data compression as described in some embodiments above.

The case where the chip is used to implement the functionality of a network device in an embodiment of the present invention will be illustrated.

The interface 1103 is for receiving code instructions and sending them to said processor.

The processor 1101 is for running code instructions to perform a method for data compression as described in some embodiments above.

Alternately, the chip 1100 further includes a memory 1102 configured to save necessary computer program and data.

Those skilled in the related art may understand that, various illustrative logical blocks and steps listed in embodiments of the present invention, may be implemented by an electronic hardware, a computer software or a combination of an electronic hardware and a computer software. Whether the function is implemented by the hardware or the software depends on specific applications and design requirements for an overall system. Those skilled in the art may implement the functions by using various methods for each specific application, but such an implementation should not be understood as beyond the protection scope of embodiments of the present invention.

A system for configuring resources is further provided in embodiments of the invention. The system includes a communication apparatus as a terminal device and a communication apparatus as a network side device in the preceding embodiment of FIG. 7, or, alternatively, the system includes a communication apparatus as a terminal device and a communication apparatus as a network side device in the preceding embodiment of FIG. 8.

A readable storage medium with instructions stored thereon is further provided in the invention. When the instructions are executed by a computer, steps of any one of the method embodiment are implemented.

A computer program product is further provided in the invention. The computer program product implements functions of the above any one method embodiment when executed by a processor.

In the above embodiments, the functions may be wholly or partially implemented by a software, a hardware, a firmware, or any combination thereof. When implemented by a software, the functions may be implemented in whole or in part in the form of a computer program product. The computer program product includes one or more computer programs. Procedures or functions according to embodiments of the present invention are wholly or partially generated when the computer program is loaded and executed on a computer. The computer may be a general purpose computer, a special purpose computer, a computer network, or other programmable device. The computer program may be stored in a computer-readable storage medium or transmitted from one computer-readable storage medium to another. For example, the computer program may be transmitted from one website, computer, server, or data center to another via wire (such as a coaxial cable, a fiber optic, a digital subscriber line (DSL)) or wireless (such as infrared, wireless, microwave). The computer-readable storage medium may be any available medium that may be accessed by a computer or a data storage device such as a server that integrates one or more of the available media, and a data center. The readable medium may be a magnetic medium (such as a floppy disk, a hard disk and a magnetic tape), an optical medium (such as a digital video disk (DVD)), or a semiconductor medium (such as a solid state disk (SSD)).

Those skilled in the art may understand that various numbers such as first and second involved in present invention are distinguished merely for convenience of description, and are not intended to limit the scope of embodiments of the invention, but also to indicate an order of precedence.

At least one in the present invention may also be described as one or more, and a plurality of may be two, three, four or more, which is not limited in the present invention. In embodiments of the present invention, for a kind of technical feature, technical features in the kind of technical feature are distinguished by "first" , "second" , "third" , "A" , "B" , "C" and "D", and there is no order of precedence or magnitude between technical features described in "first", "second", "third", "A", "B" , "C" and "D" .

Corresponding relationships indicated by tables in the present invention may be configured or predefined. Values of information in tables are only examples, and may be configured as other values, which are not limited in the invention. When corresponding relationships between information and parameters are configured, it is not always necessary to configure all corresponding relationships indicated in tables. For example, in the tables in the present invention, corresponding relationships indicated by some rows may not be configured. For another example, appropriate transformations and adjustments, such as splitting and merging, may be made based on the above tables. Names of parameters shown in headers in the tables may be other names understandable by the communication apparatus, and values or representations of the parameters may be other values or representations understandable by the communication apparatus. When the above tables are implemented, other data structures may be used, and for example, arrays, queues, containers, stacks, linear lists, pointers, linked lists, trees, graphs, structures, classes, heaps or hash tables may be used.

Predefined in the invention may be understood as defined, predefined, stored, prestored, pre-negotiated, pre-configured, solidified or pre-fired.

Those skilled in the related art may realize that, in combination with units and algorithm steps of the examples described in embodiments of the present invention, may be implemented by an electronic hardware or a combination of an electronic hardware and a computer software. Whether the functions are executed by the hardware or the software depends on a specific application and a design constraint of the technical solution. Those skilled in the art may adopt different methods for each specific application to implement the described functions, but such implementation should not be considered beyond the scope of the present invention.

Those skilled in the art may clearly understand that, a specific working process of a system, an apparatus and a unit described above may refer to a corresponding process in the above method embodiments, which will not be repeated here.

The above are only implementations of the invention. However, the protection scope of the invention is is defined by the protection scope of claims.

## Claims

1. A method for data compression, performed by a terminal device, comprising:
receiving (S21, S31, S41, S51) small data transmission, SDT, configuration information from a network side device, the SDT configuration information being used for instructing a terminal device to perform an SDT;
determining (S22) a target data compression area, wherein the target data compression area is an area where the terminal device is able to execute data compression while performing the SDT;
in response to the terminal device being located in the target data compression area, executing the data compression while performing the SDT;
wherein determining (S22) the target data compression area comprises: determining the target data compression area according to a protocol; or receiving a data compression configuration configured by the network side device and determining the target data compression area based on a data compression area configuration, wherein the data compression configuration comprises the data compression area configuration, and the data compression area configuration is used for the terminal device to determine the target data compression area;
wherein the data compression configuration comprises a data compression bearer configuration and a data compression type configuration, the data compression bearer configuration comprises at least one of: a bearer type corresponding to the data compression; or a bearer identification corresponding to the data compression.

2. The method of claim 1, further comprising:
in response to the terminal device being not located in the target data compression area, stopping executing the data compression while performing the SDT.

3. The method of claim 1, wherein determining the target data compression area according to the protocol comprises one of:
determining the target data compression area to be an access network notification area indicated by an access network notification area identification, the access network notification area identification being specified in the protocol; or
determining the target data compression area to be a target cell determined by a cell notification, the cell notification being specified by the protocol.

4. The method of claim 3,
wherein the access network notification area identification specified in the protocol comprises any one of:
the access network notification area identification being a notification area identification of an access network to which a cell, which is configured with the configured grant-small data transmission, CG-SDT, resource, belongs;
the access network notification area identification being a notification area identification of an access network to which a cell, in which the terminal device receives a connection suspension message, belongs; or
the access network notification area identification being a notification area identification of an access network to which a cell, in which the terminal device receives a connection release message, belongs; or
wherein the cell notification specified by the protocol comprises any one of:
the cell notification being a notification which indicates a cell configured with the configured grant-small data transmission, CG-SDT, resources;
the cell notification being a notification which indicates a cell in which the terminal device receives a connection suspension message; or
the cell notification being a notification which indicates a cell in which the terminal device receives a connection release message.

5. The method of claim 4,
wherein the cell in which the terminal device receives the connection suspension message comprises any one of:
a cell in which the terminal device successfully receives the connection suspension message;
a cell in which the terminal device receives the connection suspension message for a first time; or
a cell in which the terminal device receives the connection suspension message for a last time; or
wherein the cell in which the terminal device receives the connection release message comprises any one of:
a cell in which the terminal device successfully receives the connection release message;
a cell in which the terminal device receives the connection release message for a first time; or
a cell in which the terminal device receives the connection release message for a last time.

6. The method of claim 1, wherein determining the target data compression area based on the data compression area configuration comprises one of:
in case that the data compression area configuration is an access network notification area identification, determining the target data compression area to be the access network notification area indicated by the access network notification area identification; or
in case that the data compression area configuration is a cell notification, determining the target data compression area to be a target cell determined by a cell notification.

7. The method of any one of claims 1 to 6,
wherein the data compression type configuration comprises at least one of: a type indication corresponding to the data compression; an indication that the data compression continues; an indication that the data compression stops; or an indication of a direction of the data compression.

8. The method of any one of claims 1 to 7, wherein in response to the terminal device being located in the target data compression area, executing the data compression while performing the SDT comprises:
in response to a cell in which the terminal device currently resides, or a cell reselected, or a cell selected, or a type of the access network reselected belonging to the target data compression area, executing the data compression while performing the SDT.

9. The method of any one of claims 1 to 8,
wherein executing the data compression comprises at least one of:
maintaining a compressed state of a compressed entity during a packet data convergence protocol, PDCP, reestablishment; maintaining a compressed state of a decompressed entity during a PDCP reestablishment; maintaining a compressed state of a compressed entity during a PDCP recovery; maintaining a compressed state of a decompressed entity during a PDCP recovery; maintaining a compressed state of a compressed entity during a radio resource control, RRC, connection recovery; maintaining a compressed state of a decompressed entity during a RRC connection recovery; maintaining a compressed state of a compressed entity during a RRC connection release; or maintaining a compressed state of a decompressed entity during a RRC connection release; or
wherein stopping executing the data compression comprises at least one of:
resetting a compressed entity during a PDCP reestablishment; resetting a decompressed entity during a PDCP reestablishment; resetting a compressed entity during a PDCP recovery; resetting a decompressed entity during a PDCP recovery; resetting a compressed entity during a RRC connection recovery; resetting a decompressed entity during a RRC connection recovery; resetting a compressed entity during a RRC connection release; resetting a decompressed entity during a RRC connection release; releasing the data compression area configuration; or entering an idle state.

10. The method of any one of claims 1 to 8, wherein stopping executing the data compression comprises at least one of:
releasing the data compression configuration;
deleting the data compression configuration;
releasing a compression context corresponding to the data compression configuration; or
deleting a compression context corresponding to the data compression configuration.

11. A method for data compression, performed by a network side device, comprising:
sending (S61), to the terminal device, small data transmission, SDT, configuration information used for instructing a terminal device to perform an SDT;
sending a data compression configuration to the terminal device; wherein the data compression configuration comprises a data compression area configuration, and the data compression area configuration is used for the terminal device to determine a target data compression area, wherein the target data compression area is an area where the terminal device is able to execute data compression while performing the SDT;
wherein the data compression configuration further comprises: a data compression bearer configuration and a data compression type configuration, the data compression bearer configuration comprises at least one of: a bearer type corresponding to the data compression; or a bearer identification corresponding to the data compression.

12. The method of claim 11,
wherein the data compression area configuration comprises at least one of: an access network notification area identification; or a cell notification.

13. A communication apparatus (1), comprising:
a transceiver module (11) configured to receive SDT configuration information from a network side device, the SDT configuration information being used for instructing a terminal device to perform an SDT;
a processing module (12) configured to determine a target data compression area; and in response to the terminal device being located in the target data compression area, to execute data compression while performing the SDT, wherein the target data compression area is an area where the terminal device is able to execute data compression while performing the SDT;
wherein the processing module (12) is configured to determine the target data compression area according to a protocol; or the transceiver module (11) is configured to receive a data compression configuration configured by the network side device and the processing module (12) is configured to determine the target data compression area based on a data compression area configuration, wherein the data compression configuration comprises the data compression area configuration, and the data compression area configuration is used for the terminal device to determine the target data compression area;
wherein the data compression configuration comprises a data compression bearer configuration and a data compression type configuration, the data compression bearer configuration comprises at least one of: a bearer type corresponding to the data compression; or a bearer identification corresponding to the data compression.

14. A communication apparatus (1), comprising:
a transceiver module (11) configured to send SDT configuration information used for instructing a terminal device to perform the SDT to the terminal device, and to send a data compression configuration to the terminal device; wherein the data compression configuration comprises a data compression area configuration, and the data compression area configuration is used for the terminal device to determine a target data compression area, wherein the target data compression area is an area where the terminal device is able to execute data compression while performing the SDT;
wherein the data compression configuration further comprises: a data compression bearer configuration and a data compression type configuration, the data compression bearer configuration comprises at least one of: a bearer type corresponding to the data compression; or a bearer identification corresponding to the data compression.

## Patentansprüche

1. Ein Verfahren zur Datenkomprimierung, das von einem Endgerät durchgeführt wird, mit folgenden Schritten:
Empfangen (S21, S31, S41, S51) von Kleine-Datenübertragung, SDT-'Konfigurationsinformationen von einem netzwerkseitigen Gerät, wobei die SDT-Konfigurationsinformationen dazu verwendet werden, ein Endgerät dahingehend anzuweisen, eine SDT durchzuführen;
Bestimmen (S22) eines Zieldatenkomprimierungsbereichs, wobei der Zieldatenkomprimierungsbereich ein Bereich ist, in dem das Endgerät in der Lage ist, eine Datenkomprimierung auszuführen, während es die SDT durchführt;
ansprechend darauf, dass sich das Endgerät in dem Zieldatenkomprimierungsbereich befindet, Ausführen der Datenkomprimierung, während es die SDT durchführt;
wobei das Bestimmen (S22) des Zieldatenkomprimierungsbereichs folgende Schritte aufweist: Bestimmen des Zieldatenkomprimierungsbereichs gemäß einem Protokoll; oder Empfangen einer von dem netzwerkseitigen Gerät konfigurierten Datenkomprimierungskonfiguration und Bestimmen des Zieldatenkomprimierungsbereichs basierend auf einer Datenkomprimierungsbereichskonfiguration, wobei die Datenkomprimierungskonfiguration die Datenkomprimierungsbereichskonfiguration aufweist und die Datenkomprimierungsbereichskonfiguration für das Endgerät verwendet wird, um den Zieldatenkomprimierungsbereich zu bestimmen;
wobei die Datenkomprimierungskonfiguration eine Datenkomprimierungsträgerkonfiguration und eine Datenkomprimierungstypkonfiguration aufweist, wobei die Datenkomprimierungsträgerkonfiguration zumindest eines der Folgenden aufweist: einen Trägertyp, der der Datenkomprimierung entspricht; oder eine Trägeridentifikation, die der Datenkomprimierung entspricht.

2. Das Verfahren gemäß Anspruch 1, das ferner folgenden Schritt aufweist:
ansprechend darauf, dass sich das Endgerät nicht in dem Zieldatenkomprimierungsbereich befindet, Stoppen des Ausführens der Datenkomprimierung, während es die SDT durchführt.

3. Das Verfahren gemäß Anspruch 1, wobei das Bestimmen des Zieldatenkomprimierungsbereichs gemäß dem Protokoll einen der folgenden Schritte aufweist:
Bestimmen, dass der Zieldatenkomprimierungsbereich ein Zugangsnetzwerkbenachrichtigungsbereich ist, der durch eine Zugangsnetzwerkbenachrichtigungsbereichsidentifikation angezeigt wird, wobei die Zugangsnetzwerkbenachrichtigungsbereichsidentifikation in dem Protokoll spezifiziert ist; oder
Bestimmen, dass der Zieldatenkomprimierungsbereich eine Zielzelle ist, die durch eine Zellenbenachrichtigung bestimmt wird, wobei die Zellenbenachrichtigung durch das Protokoll spezifiziert ist.

4. Das Verfahren gemäß Anspruch 3,
wobei die in dem Protokoll spezifizierte Zugangsnetzwerkbenachrichtigungsbereichsidentifikation eines der Folgenden aufweist:
die Zugangsnetzwerkbenachrichtigungsbereichsidentifikation ist eine Benachrichtigungsbereichsidentifikation eines Zugangsnetzwerks, zu dem eine Zelle gehört, die mit der Konfigurierte-Bewilligung-Kleine-Datenübertragung, CG-SDT-,Ressource konfiguriert ist;
die Zugangsnetzwerkbenachrichtigungsbereichsidentifikation ist eine Benachrichtigungsbereichsidentifikation eines Zugangsnetzwerks, zu dem eine Zelle gehört, in der das Endgerät eine Verbindungsunterbrechungsnachricht empfängt; oder
die Zugangsnetzwerkbenachrichtigungsbereichsidentifikation ist eine Benachrichtigungsbereichsidentifikation eines Zugangsnetzwerks, zu dem eine Zelle gehört, in der das Endgerät eine Verbindungsfreigabenachricht empfängt; oder
wobei die durch das Protokoll spezifizierte Zellenbenachrichtigung eines der Folgenden aufweist:
die Zellenbenachrichtigung ist eine Benachrichtigung, die eine Zelle angibt, die mit den Konfigurierte-Bewilligung-Kleine-Datenübertragung, CG-SDT-,Ressourcen konfiguriert ist;
die Zellenbenachrichtigung ist eine Benachrichtigung, die eine Zelle angibt, in der das Endgerät eine Verbindungsunterbrechungsnachricht empfängt; oder
die Zellenbenachrichtigung ist eine Benachrichtigung, die eine Zelle angibt, in der das Endgerät eine Verbindungsfreigabenachricht empfängt.

5. Das Verfahren gemäß Anspruch 4,
wobei die Zelle, in der das Endgerät die Verbindungsunterbrechungsnachricht empfängt, eine der folgenden Zellen aufweist:
eine Zelle, in der das Endgerät die Verbindungsunterbrechungsnachricht erfolgreich empfängt;
eine Zelle, in der das Endgerät die Verbindungsunterbrechungsnachricht ein erstes Mal empfängt; oder
eine Zelle, in der das Endgerät die Verbindungsunterbrechungsnachricht ein letztes Mal empfängt; oder
wobei die Zelle, in der das Endgerät die Verbindungsfreigabenachricht empfängt, eine der folgenden Zellen aufweist:
eine Zelle, in der das Endgerät die Verbindungsfreigabenachricht erfolgreich empfängt;
eine Zelle, in der das Endgerät die Verbindungsfreigabenachricht ein erstes Mal empfängt; oder
eine Zelle, in der das Endgerät die Verbindungsfreigabenachricht ein letztes Mal empfängt.

6. Das Verfahren gemäß Anspruch 1, wobei das Bestimmen des Zieldatenkomprimierungsbereichs basierend auf der Datenkomprimierungsbereichskonfiguration einen der folgenden Schritte aufweist:
falls die Datenkomprimierungsbereichskonfiguration eine Zugangsnetzwerkbenachrichtigungsbereichsidentifikation ist, Bestimmen, dass der Zieldatenkomprimierungsbereich der Zugangsnetzwerkbenachrichtigungsbereich ist, der durch die Zugangsnetzwerkbenachrichtigungsbereichsidentifikation angegeben wird; oder
falls die Datenkomprimierungsbereichskonfiguration eine Zellenbenachrichtigung ist, Bestimmen, dass der Zieldatenkomprimierungsbereich eine Zielzelle ist, die durch eine Zellenbenachrichtigung bestimmt wird.

7. Das Verfahren gemäß einem der Ansprüche 1 bis 6,
wobei die Datenkomprimierungstypkonfiguration zumindest eines der Folgenden aufweist: eine Typangabe, die der Datenkomprimierung entspricht; eine Angabe, dass die Datenkomprimierung fortgesetzt wird; eine Angabe, dass die Datenkomprimierung stoppt; oder eine Angabe einer Richtung der Datenkomprimierung.

8. Das Verfahren gemäß einem der Ansprüche 1 bis 7, wobei ansprechend darauf, dass sich das Endgerät in dem Zieldatenkomprimierungsbereich befindet, das Ausführen der Datenkomprimierung, während es die SDT durchführt, folgenden Schritt aufweist:
ansprechend darauf, dass eine Zelle, in der sich das Endgerät gegenwärtig befindet, oder eine Zelle, die neu ausgewählt wird, oder eine Zelle, die ausgewählt wird, oder ein Typ des Zugangsnetzwerks, das neu ausgewählt wird, zu dem Zieldatenkomprimierungsbereich gehört, Ausführen der Datenkomprimierung, während es die SDT durchführt.

9. Das Verfahren gemäß einem der Ansprüche 1 bis 8,
wobei das Ausführen der Datenkomprimierung zumindest einen der folgenden Schritte aufweist:
Aufrechterhalten eines komprimierten Zustands einer komprimierten Entität während einer Paketdatenkonvergenzprotokoll-, PDCP-,Wiederherstellung; Aufrechterhalten eines komprimierten Zustands einer dekomprimierten Entität während einer PDCP-Wiederherstellung; Aufrechterhalten eines komprimierten Zustands einer komprimierten Entität während einer PDCP-Wiederherstellung; Aufrechterhalten eines komprimierten Zustands einer dekomprimierten Entität während einer PDCP-Wiederherstellung; Aufrechterhalten eines komprimierten Zustands einer komprimierten Entität während einer Funkressourcensteuerungs-, RRC-'Verbindungswiederherstellung; Aufrechterhalten eines komprimierten Zustands einer dekomprimierten Entität während einer RRC-Verbindungswiederherstellung; Aufrechterhalten eines komprimierten Zustands einer komprimierten Entität während einer RRC-Verbindungsfreigabe; oder Aufrechterhalten eines komprimierten Zustands einer dekomprimierten Entität während einer RRC-Verbindungsfreigabe; oder
wobei das Stoppen des Ausführens der Datenkomprimierung zumindest einen der folgenden Schritte aufweist:
Zurücksetzen einer komprimierten Entität während einer PDCP-Wiederherstellung; Zurücksetzen einer dekomprimierten Entität während einer PDCP-Wiederherstellung; Zurücksetzen einer komprimierten Entität während einer PDCP-Wiederherstellung; Zurücksetzen einer dekomprimierten Entität während einer PDCP-Wiederherstellung; Zurücksetzen einer komprimierten Entität während einer RRC-Verbindungswiederherstellung; Zurücksetzen einer dekomprimierten Entität während einer RRC-Verbindungswiederherstellung; Zurücksetzen einer komprimierten Entität während einer RRC-Verbindungsfreigabe; Zurücksetzen einer dekomprimierten Entität während einer RRC-Verbindungsfreigabe; Freigeben der Datenkomprimierungsbereichskonfiguration; oder Eintreten in einen Ruhezustand.

10. Das Verfahren gemäß einem der Ansprüche 1 bis 8, wobei das Stoppen des Ausführens der Datenkomprimierung zumindest einen der folgenden Schritte aufweist:
Freigeben der Datenkomprimierungskonfiguration;
Löschen der Datenkomprimierungskonfiguration;
Freigeben eines Komprimierungskontextes, der der Datenkomprimierungskonfiguration entspricht; oder
Löschen eines Komprimierungskontextes, der der Datenkomprimierungskonfiguration entspricht.

11. Ein Verfahren zur Datenkomprimierung, das von einem netzwerkseitigen Gerät durchgeführt wird, mit folgenden Schritten:
Senden (S61), an das Endgerät, von Kleine-Datenübertragung, SDT-,Konfigurationsinformationen, die dazu verwendet werden, ein Endgerät dahingehend anzuweisen, eine SDT durchzuführen;
Senden einer Datenkomprimierungskonfiguration an das Endgerät; wobei die Datenkomprimierungskonfiguration eine Datenkomprimierungsbereichskonfiguration aufweist und die Datenkomprimierungsbereichskonfiguration für das Endgerät verwendet wird, um einen Zieldatenkomprimierungsbereich zu bestimmen, wobei der Zieldatenkomprimierungsbereich ein Bereich ist, in dem das Endgerät in der Lage ist, eine Datenkomprimierung auszuführen, während es die SDT durchführt;
wobei die Datenkomprimierungskonfiguration ferner Folgendes aufweist: eine Datenkomprimierungsträgerkonfiguration und eine Datenkomprimierungstypkonfiguration, wobei die Datenkomprimierungsträgerkonfiguration zumindest eines der Folgenden aufweist: einen Trägertyp, der der Datenkomprimierung entspricht; oder eine Trägeridentifikation, die der Datenkomprimierung entspricht.

12. Das Verfahren gemäß Anspruch 11,
wobei die Datenkomprimierungsbereichskonfiguration zumindest eines der Folgenden aufweist: eine Zugangsnetzwerkbenachrichtigungsbereichsidentifikation; oder eine Zellenbenachrichtigung.

13. Eine Kommunikationsvorrichtung (1), die folgende Merkmale aufweist:
ein Transceiver-Modul (11), das dazu konfiguriert ist, SDT-Konfigurationsinformationen von einem netzwerkseitigen Gerät zu empfangen, wobei die SDT-Konfigurationsinformationen dazu verwendet werden, ein Endgerät dahingehend anzuweisen, eine SDT durchzuführen;
ein Verarbeitungsmodul (12), das dazu konfiguriert ist, einen Zieldatenkomprimierungsbereich zu bestimmen; und ansprechend darauf, dass sich das Endgerät in dem Zieldatenkomprimierungsbereich befindet, eine Datenkomprimierung auszuführen, während es die SDT durchführt, wobei der Zieldatenkomprimierungsbereich ein Bereich ist, in dem das Endgerät in der Lage ist, eine Datenkomprimierung auszuführen, während es die SDT durchführt;
wobei das Verarbeitungsmodul (12) dazu konfiguriert ist, den Zieldatenkomprimierungsbereich gemäß einem Protokoll zu bestimmen; oder das Transceiver-Modul (11) dazu konfiguriert ist, eine von dem netzwerkseitigen Gerät konfigurierte Datenkomprimierungskonfiguration zu empfangen, und das Verarbeitungsmodul (12) dazu konfiguriert ist, den Zieldatenkomprimierungsbereich basierend auf einer Datenkomprimierungsbereichskonfiguration zu bestimmen, wobei die Datenkomprimierungskonfiguration die Datenkomprimierungsbereichskonfiguration aufweist und die Datenkomprimierungsbereichskonfiguration für das Endgerät verwendet wird, um den Zieldatenkomprimierungsbereich zu bestimmen;
wobei die Datenkomprimierungskonfiguration eine Datenkomprimierungsträgerkonfiguration und eine Datenkomprimierungstypkonfiguration aufweist, wobei die Datenkomprimierungsträgerkonfiguration zumindest eines der Folgenden aufweist: einen Trägertyp, der der Datenkomprimierung entspricht; oder eine Trägeridentifikation, die der Datenkomprimierung entspricht.

14. Eine Kommunikationsvorrichtung (1), die folgende Merkmale aufweist:
ein Transceiver-Modul (11), das dazu konfiguriert ist, SDT-Konfigurationsinformationen, die dazu verwendet werden, ein Endgerät dahingehend anzuweisen, die SDT durchzuführen, an das Endgerät zu senden und eine Datenkomprimierungskonfiguration an das Endgerät zu senden; wobei die Datenkomprimierungskonfiguration eine Datenkomprimierungsbereichskonfiguration aufweist und die Datenkomprimierungsbereichskonfiguration für das Endgerät verwendet wird, um einen Zieldatenkomprimierungsbereich zu bestimmen, wobei der Zieldatenkomprimierungsbereich ein Bereich ist, in dem das Endgerät in der Lage ist, eine Datenkomprimierung auszuführen, während es die SDT durchführt;
wobei die Datenkomprimierungskonfiguration ferner Folgendes aufweist: eine Datenkomprimierungsträgerkonfiguration und eine Datenkomprimierungstypkonfiguration, wobei die Datenkomprimierungsträgerkonfiguration zumindest eines der Folgenden aufweist: einen Trägertyp, der der Datenkomprimierung entspricht; oder eine Trägeridentifikation, die der Datenkomprimierung entspricht.

## Revendications

1. Procédé de compression de données, réalisé par un dispositif terminal, comprenant :
la réception (S21, S31, S41, S51) d'informations de configuration de transmission de petites données (SDT) d'un dispositif côté réseau, les informations de configuration SDT étant utilisées pour ordonner à un dispositif terminal d'effectuer une SDT ;
la détermination (S22) d'une zone de compression de données cibles, dans laquelle la zone de compression de données cibles est une zone dans laquelle le dispositif terminal est capable d'exécuter une compression de données tout en effectuant le SDT ;
en réponse au fait que le dispositif terminal est localisé dans la zone de compression de données cibles, exécuter la compression de données tout en effectuant le SDT ;
dans lequel la détermination (S22) de la zone de compression de données cibles comprend : la détermination de la zone de compression de données cibles selon un protocole ; ou la réception d'une configuration de compression de données configurée par le dispositif côté réseau et la détermination de la zone de compression de données cibles sur la base d'une configuration de zone de compression de données, dans laquelle la configuration de compression de données comprend la configuration de zone de compression de données, et la configuration de zone de compression de données est utilisée pour le dispositif terminal pour déterminer la zone de compression de données cibles ;
dans lequel la configuration de compression de données comprend une configuration de support de compression de données et une configuration de type de compression de données, la configuration de support de compression de données comprend au moins l'un de : un type de support correspondant à la compression de données ; ou une identification de support correspondant à la compression de données.

2. Procédé selon la revendication 1, comprenant en outre :
en réponse au fait que le dispositif terminal n'est pas localisé dans la zone de compression de données cibles, l'interruption de l'exécution de la compression de données tout en effectuant le SDT.

3. Procédé selon la revendication 1, dans lequel la détermination de la zone de compression de données cibles selon le protocole comprend l'un de :
la définition de la zone de compression de données cibles comme étant une zone de notification de réseau d'accès indiquée par une identification de zone de notification de réseau d'accès, l'identification de zone de notification de réseau d'accès étant spécifiée dans le protocole ; ou
la définition de la zone de compression de données cibles comme étant une cellule cible déterminée par une notification de cellule, la notification de cellule étant spécifiée par le protocole.

4. Procédé selon la revendication 3,
dans lequel l'identification de zone de notification de réseau d'accès spécifiée dans le protocole comprend l'un quelconque de :
l'identification de zone de notification de réseau d'accès étant une identification de zone de notification d'un réseau d'accès auquel une cellule, qui est configurée avec la ressource de transmission de petites données d'autorisation configurée (CG-SDT), appartient ;
l'identification de zone de notification de réseau d'accès étant une identification de zone de notification d'un réseau d'accès auquel une cellule, dans laquelle le dispositif terminal reçoit un message de suspension de connexion, appartient ; ou
l'identification de zone de notification de réseau d'accès étant une identification de zone de notification d'un réseau d'accès auquel la cellule, dans laquelle le dispositif terminal reçoit un message de libération de connexion, appartient ; ou
dans lequel la notification de cellule spécifiée par le protocole comprend l'un quelconque de :
la notification de cellule est une notification qui indique une cellule configurée avec les ressources de transmission de petites données d'autorisation configurée (CG-SDT) ;
la notification de cellule est une notification qui indique une cellule dans laquelle le dispositif terminal reçoit un message de suspension de connexion ; ou
la notification de cellule est une notification qui indique une cellule dans laquelle le dispositif terminal reçoit un message de libération de connexion.

5. Procédé selon la revendication 4,
dans lequel la cellule dans laquelle le dispositif terminal reçoit le message de suspension de connexion comprend l'un quelconque de :
une cellule dans laquelle le dispositif terminal reçoit avec succès le message de suspension de connexion ;
une cellule dans laquelle le dispositif terminal reçoit le message de suspension de connexion pour une première fois ; ou
une cellule dans laquelle le dispositif terminal reçoit le message de suspension de connexion pour une dernière fois ; ou
dans lequel la cellule dans laquelle le dispositif terminal reçoit le message de libération de connexion comprend l'un quelconque de :
une cellule dans laquelle le dispositif terminal reçoit avec succès le message de libération de connexion ;
une cellule dans laquelle le dispositif terminal reçoit le message de libération de connexion pour une première fois ;
ou
une cellule dans laquelle le dispositif terminal reçoit le message de libération de connexion pour une dernière fois.

6. Procédé selon la revendication 1, dans lequel la détermination de la zone de compression de données cibles sur la base de la configuration de zone de compression de données comprend l'un de :
dans le cas où la configuration de zone de compression de données est une identification de zone de notification de réseau d'accès, la détermination de la zone de compression de données cibles comme étant la zone de notification de réseau d'accès indiquée par l'identification de zone de notification de réseau d'accès ; ou
dans le cas où la configuration de zone de compression de données est une notification de cellule, la détermination de la zone de compression de données cibles comme étant une cellule cible déterminée par une notification de cellule.

7. Procédé selon l'une quelconque des revendications 1 à 6,
dans lequel la configuration de type de compression de données comprend au moins l'un de : une indication de type correspondant à la compression de données ; une indication que la compression de données continue ; une indication que la compression de données s'interrompt ; ou une indication d'une direction de la compression de données.

8. Procédé selon l'une quelconque des revendications 1 à 7, dans lequel, en réponse au fait que le dispositif terminal est localisé dans la zone de compression de données cibles, l'exécution de la compression de données tout en effectuant le SDT comprend :
en réponse à une cellule dans laquelle le dispositif terminal se trouve actuellement, ou à une cellule resélectionnée, ou à une cellule sélectionnée, ou à un type du réseau d'accès resélectionné appartenant à la zone de compression de données cibles, l'exécution de la compression de données tout en effectuant le SDT.

9. Procédé selon l'une quelconque des revendications 1 à 8,
dans lequel l'exécution de la compression de données comprend au moins l'un de :
le maintien d'un état compressé d'une entité compressée pendant un rétablissement de protocole de convergence de données par paquets (PDCP) ; le maintien d'un état décompressé d'une entité décompressée pendant un rétablissement PDCP ; le maintien d'un état compressé d'une entité compressée pendant une récupération PDCP ; le maintien d'un état compressé d'une entité décompressée pendant une récupération PDCP ; le maintien d'un état compressé d'une entité compressée pendant une récupération de connexion de contrôle de ressource radio (RRC) ; le maintien d'un état compressé d'une entité décompressée pendant une récupération de connexion RRC ; le maintien d'un état compressé d'une entité compressée pendant une libération de connexion RRC ; ou le maintien d'un état compressé d'une entité décompressée pendant une libération de connexion RRC ; ou
dans lequel l'interruption de l'exécution de la compression de données comprend au moins l'une de :
la réinitialisation d'une entité compressée pendant un rétablissement PDCP ; la réinitialisation d'une entité décompressée pendant un rétablissement PDCP ; la réinitialisation d'une entité compressée pendant une récupération PDCP ; la réinitialisation d'une entité décompressée pendant une récupération PDCP ; la réinitialisation d'une entité compressée pendant une récupération de connexion RRC ; la réinitialisation d'une entité décompressée pendant une récupération de connexion RRC ; la réinitialisation d'une entité compressée pendant une libération de connexion RRC ; la réinitialisation d'une entité décompressée pendant une libération de connexion RRC ; la libération de la configuration de zone de compression de données ; ou l'entrée dans un état de repos.

10. Procédé selon l'une quelconque des revendications 1 à 8, dans lequel l'interruption de l'exécution de la compression de données comprend au moins l'une de :
la libération de la configuration de compression de données ;
la suppression de la configuration de compression de données ;
la libération d'un contexte de compression correspondant à la configuration de compression de données ; ou
la suppression d'un contexte de compression correspondant à la configuration de compression de données.

11. Procédé de compression de données, effectué par un dispositif côté réseau, comprenant :
l'envoi (S61), au dispositif terminal, d'informations de configuration de transmission de petites données (SDT) utilisées pour ordonner à un dispositif terminal d'effectuer une SDT ;
l'envoi d'une configuration de compression de données au dispositif terminal ; dans lequel la configuration de compression de données comprend une configuration de zone de compression de données, et la configuration de zone de compression de données est utilisée pour le dispositif terminal pour déterminer une zone de compression de données cibles, dans lequel la zone de compression de données cibles est une zone dans laquelle le dispositif terminal est capable d'exécuter une compression de données tout en effectuant le SDT ;
dans laquelle la configuration de compression de données comprend en outre : une configuration de support de compression de données et une configuration de type de compression de données, la configuration de support de compression de données comprend au moins l'un de : un type de support correspondant à la compression de données ; ou une identification de support correspondant à la compression de données.

12. Procédé selon la revendication 11,
dans laquelle la configuration de zone de compression de données comprend au moins l'un de : une identification de zone de notification de réseau d'accès ; ou une notification de cellule.

13. Appareil de communication (1), comprenant :
un module émetteur-récepteur (11) configuré pour recevoir des informations de configuration SDT d'un dispositif côté réseau, les informations de configuration SDT étant utilisées pour ordonner à un dispositif terminal d'effectuer un SDT ;
un module de traitement (12) configuré pour déterminer une zone de compression de données cibles ; et en réponse au fait que le dispositif terminal est localisé dans la zone de compression de données cibles, pour exécuter une compression de données tout en effectuant le SDT, dans lequel la zone de compression de données cibles est une zone dans laquelle le dispositif terminal est capable d'exécuter une compression de données tout en effectuant le SDT ;
dans lequel le module de traitement (12) est configuré pour déterminer la zone de compression de données cibles selon un protocole ; ou le module émetteur-récepteur (11) est configuré pour recevoir une configuration de compression de données configurée par le dispositif côté réseau et le module de traitement (12) est configuré pour déterminer la zone de compression de données cibles sur la base d'une configuration de zone de compression de données, dans lequel la configuration de compression de données comprend la configuration de zone de compression de données, et la configuration de zone de compression de données est utilisée pour le dispositif terminal pour déterminer la zone de compression de données cibles ;
dans lequel la configuration de compression de données comprend une configuration de support de compression de données et une configuration de type de compression de données, la configuration de support de compression de données comprend au moins l'un de : un type de support correspondant à la compression de données ; ou une identification de support correspondant à la compression de données.

14. Appareil de communication (1), comprenant :
un module émetteur-récepteur (11) configuré pour envoyer des informations de configuration SDT utilisées pour ordonner à un dispositif terminal d'effectuer le SDT au dispositif terminal, et pour envoyer une configuration de compression de données au dispositif terminal ; dans lequel la configuration de compression de données comprend une configuration de zone de compression de données, et la configuration de zone de compression de données est utilisée pour le dispositif terminal pour déterminer une zone de compression de données cibles, dans lequel la zone de compression de données cibles est une zone dans laquelle le dispositif terminal est capable d'exécuter une compression de données tout en effectuant le SDT ;
dans laquelle la configuration de compression de données comprend en outre : une configuration de support de compression de données et une configuration de type de compression de données, la configuration de support de compression de données comprend au moins l'un de : un type de support correspondant à la compression de données ; ou une identification de support correspondant à la compression de données.
